# EUROPEAN PATENT SPECIFICATION

(11) **EP 0 740 421 B1**
(45) Date of publication and mention of the grant of the patent: **30.12.1998**
(21) Application number: 96106646.1
(22) Date of filing: 26.04.1996
(51) Int. Cl.: H03L 1/02

(54) **Temperature-compensated piezoelectric oscillator**
Temperaturkompensierter piezoelektrischer Oszillator
Oscillateur piézo-électrique compensé en température

(30) Priority: 27.04.1995 JP 104011/95; 18.03.1996 JP 61493/96
(43) Date of publication of application: 30.10.1996
(73) Proprietor: SEIKO EPSON CORPORATION, Tokyo 163 (JP)
(72) Inventor: Oka, Manabu, c/o Seiko Epson Corp., Suwa-shi, Nagano-ken 392 (JP); Kikushima, Masayuki, c/o Seiko Epson Corp., Suwa-shi, Nagano-ken 392 (JP); Ichinose, Kazunari, c/o Seiko Epson Corp., Suwa-shi, Nagano-ken 392 (JP)
(74) Representative: Hoffmann, Eckart, Dipl.-Ing.

(56) References cited:
- DE-A- 4 209 843
- JP-A- 41 969
- US-A- 5 081 431
- PATENT ABSTRACTS OF JAPAN vol. 016, no. 112 (E-1180), 19 March 1992 & JP-A-03 283904 (KINSEKI LTD), 13 December 1991,
- PATENT ABSTRACTS OF JAPAN vol. 005, no. 064 (P-059), 30 April 1981 & JP-A-56 016891 (MITSUBISHI ELECTRIC CORP), 18 February 1981,
- PATENT ABSTRACTS OF JAPAN vol. 013, no. 062 (E-715), 13 February 1989 & JP-A-63 252004 (SEIKO EPSON CORP), 19 October 1988,

## Description

The present invention relates to a temperature-compensated piezoelectric oscillator for use in a reference frequency source for communications equipment or the like.

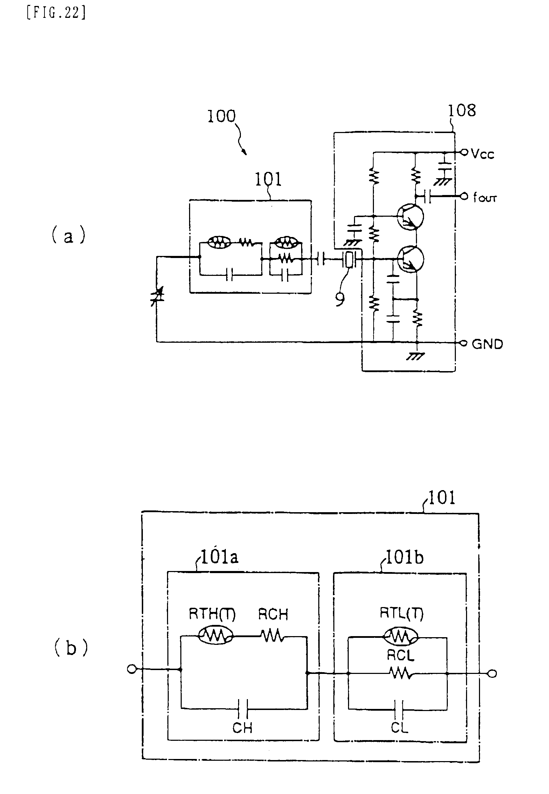

The analog temperature-compensated piezoelectric oscillator shown in Fig. 22(a) has conventionally been used as a piezoelectric oscillator circuit which is compensated for frequency variations due to temperature. For example, JP-A-1-1969 discloses a circuit having such a construction. As shown in the figure, a temperature-compensated piezoelectric oscillator 100 comprises a piezoelectric vibrator 9, a Colpitts-type oscillator circuit 108 for driving vibrator 9, and a temperature compensating circuit network 101 to compensate for frequency-temperature characteristics.

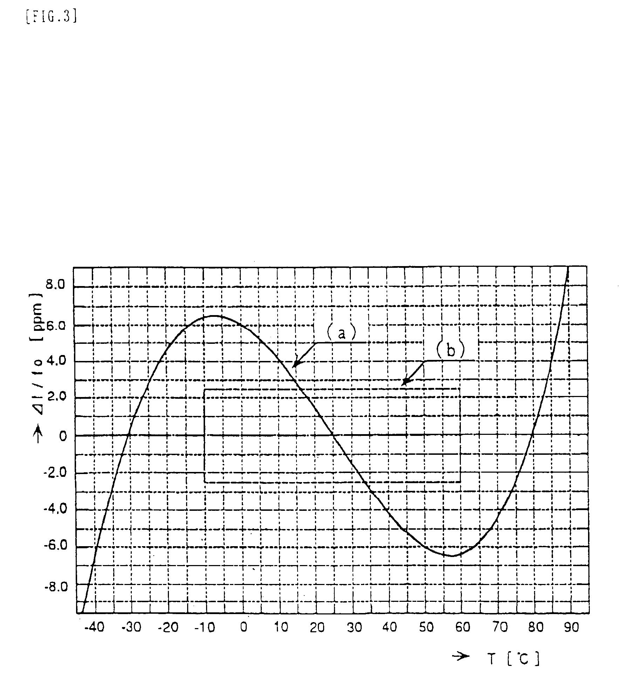

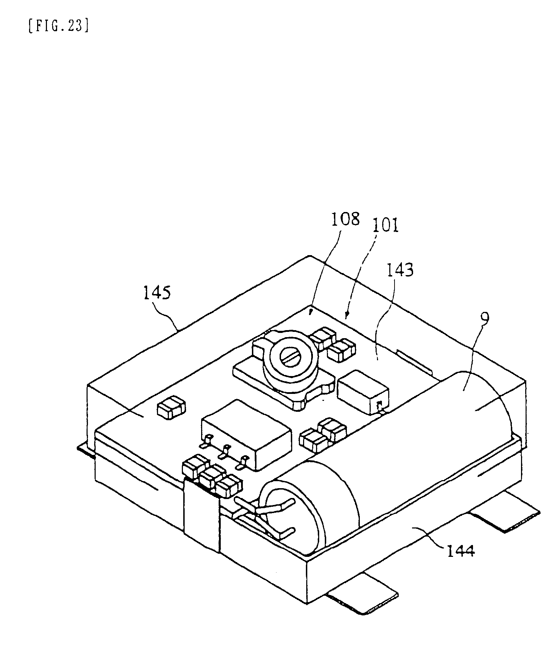

Referring now to Fig. 22(b), network 101 is constructed by connecting a high-temperature compensating circuit 101a and a low-temperature compensating circuit 101b in series. The high-temperature compensating circuit 101a is made by connecting a thermistor RTH(T) and a high-temperature side temperature characteristic adjustment resistor RCH in series, and connecting the thermistor RTH(T) and the resistor RCH in parallel with a capacitor CH, and the low-temperature compensating circuit 101b is made by connecting a thermistor RTL(T), a low-temperature side temperature characteristic adjustment resistor RCL, and a capacitor CL in parallel. In this arrangement, network 101 keeps the output frequency fout of the Colpitts-type oscillator circuit 108 within a predetermined range by changing the reactance of the Colpitts-type oscillator circuit 108 to compensate for the frequency-temperature characteristics of vibrator 9. The network 101 changes reactance in such a manner that the frequency-temperature characteristics of vibrator 9, for example, the cubic characteristics (refer to Fig. 3) of an AT cut crystal vibrator, is at least partially compensated. These circuits are soldered on both the top and bottom sides of a circuit board 143 (only the top side is shown in Fig. 23), and then they are all mounted on a resin base 144 and then housed in a metal cover 145.

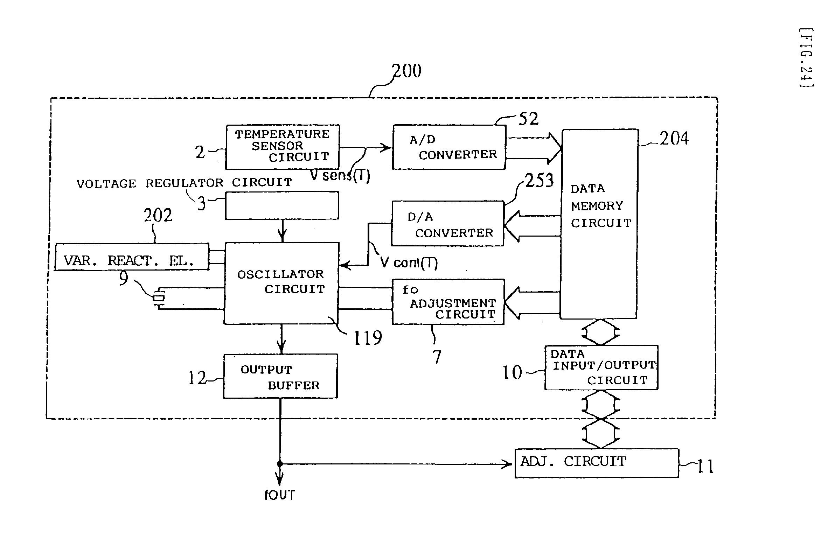

Fig. 24 is another example of a prior art temperature-compensated piezoelectric oscillator in which frequency changes due to temperature variations are digitally compensated. As shown, temperature-compensated piezoelectric oscillator 200 comprises a temperature sensor circuit 2 for sensing ambient temperature T and generating a voltage Vsens(T) in response to the sensed temperature, an A/D converter 52 for converting the voltage Vsens(T) into digital temperature data, a data memory circuit 204 for putting out compensating data in response to the temperature data, a D/A converter 253 for converting the compensating data into control voltage Vcont(T), and an oscillator circuit 119, wherein the control voltage Vcont(T), responsive to the ambient temperature T, is used to control the output frequency of oscillator circuit 119. The compensating data is stored in data memory circuit 204 beforehand in an adjustment stage during manufacturing, using an external f_{O} temperature characteristic adjustment circuit 11 and an internal data input/output circuit 10.

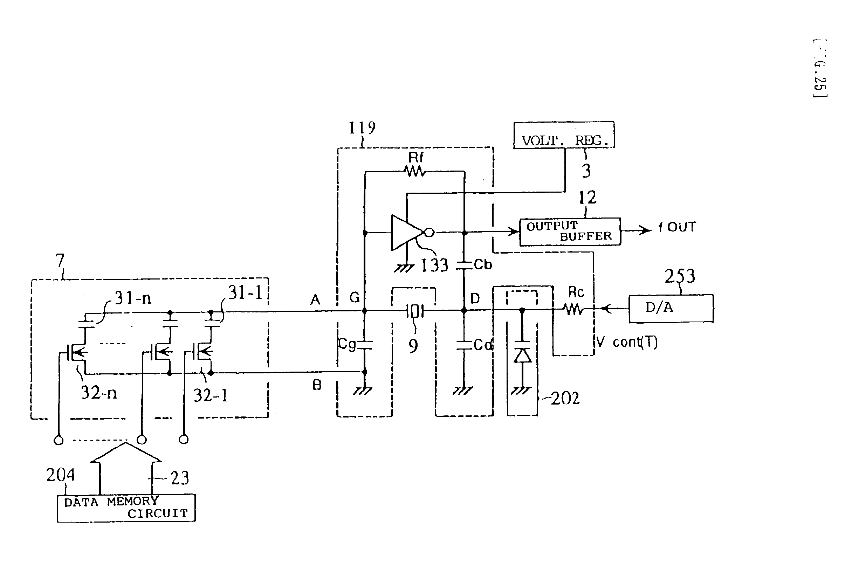

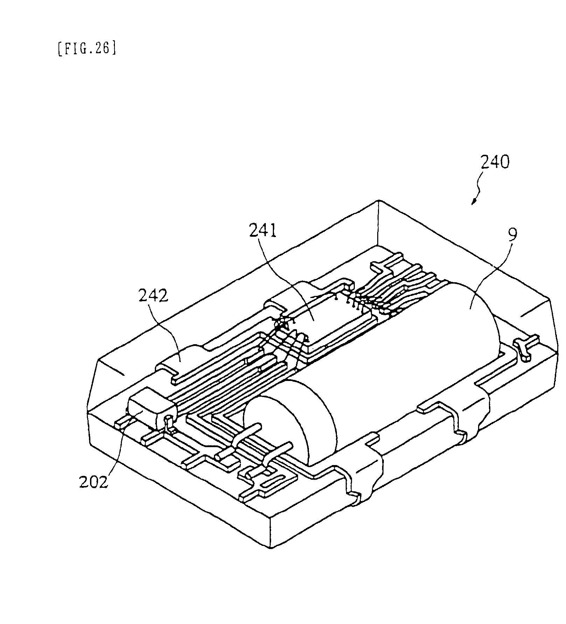

As shown in Fig. 24 and Fig. 25, further connected to the oscillator circuit 119 are a piezoelectric vibrator 9, a voltage regulator circuit 3, an f_{O} adjustment circuit 7, a variable reactance element 202, and an output buffer 12. The f_{O} adjustment circuit 7 adjusts a reference frequency f_{O} in response to frequency setting data received from data memory circuit 204. The frequency setting data, which is used to compensate frequency deviation due to manufacturing variations of vibrator 9, is stored beforehand into data memory circuit 204 through external adjustment circuit 11 and internal data input/output circuit 10 in a way similar to the way in which the compensating data is stored. The variable reactance element 202 changes its reactance in response to the control voltage Vcont(T) and compensates the frequency-temperature characteristics of vibrator 9. In this manner, the oscillation frequency of oscillator 200 is kept within a predetermined range by variable reactance element 202. The oscillator 200, as shown in Fig. 26, may comprise vibrator 9, variable reactance element 202, and a temperature-compensated oscillator IC 241 into which the rest of the circuitry is integrated. These three components are typically mounted on a lead frame 242 and packaged integrally into a plastic mold 240.

In oscillator 100 and oscillator 200, to compensate for frequency-temperature characteristics and thereby achieve a high-accuracy frequency characteristic, reactance needs to be precisely changed in response to the ambient temperature T. To this end, temperature-compensating circuit network 101 and variable reactance element 202 are installed externally to oscillator circuit 108 or 119, respectively.

Generally, oscillator 100 employs bipolar transistors which exhibit smaller changes in frequency over wider ranges of temperature as compared to CMOS devices, and along with these, resistors and thermistors of a high resistance and a high accuracy and capacitors of a large capacitance and a high accuracy are used. Generally speaking, these components are difficult to integrate into an IC structure; thus, discrete components must be used in oscillator 100. A large component count results, presenting difficulty in miniaturization of the oscillator. Since the components are soldered onto the top and bottom sides of a circuit board 143, mounting through reflow is impossible. Furthermore, production efficiency is hindered by a clumsy procedure required to adjust network 101. According to this procedure, temporary resistors for RCH and RCL are installed, the temperature characteristic of the oscillator is determined, and then the temporary resistors are replaced by permanent resistors RCH and RCL of appropriate values.

On the other hand, oscillator 200 may comprise no more than vibrator 9, variable reactance element 202 and IC 241, thereby promoting miniaturization to some extent. Production efficiency is also promoted to some extent because adjustment of the means for temperature compensation may be done easily by storing compensating data and frequency setting data in data memory circuit 204. Unfortunately, variable reactance element 202, typically a varicap diode, is required but is difficult to integrate into a CMOS IC. Even if variable reactance element 202 is integrated, precise compensation of frequency-temperature characteristic is more difficult because an integrated element is greatly inferior to an external element with respect to linearity and dynamic range.

Mere substitution of a digital circuit such as f_{O} adjustment circuit 7 for analog variable reactance element 202 is not practicable because, unlike compensation for static variations of elements at an initial setting, compensation of dynamic variations such as frequency-temperature characteristics is corrupted by noise due to discrete jumps in digital compensating data when it changes in response to ambient temperature T. Because mere substitution of digital compensation for analog compensation is not practical, oscillator 200 essentially requires an external analog variable reactance element 202. This limits miniaturization and increases manufacturing costs.

JP-A-3-283904 discloses a temperature-compensated piezoelectric oscillator in accordance with the preamble of claim 1. There, the power supply current supplied to an inverter is varied in response to ambient temperature changes so as to stabilize the oscillation.

JP-A-56-016891 discloses a temperature-compensated oscillating circuit for a watch wherein the power source voltage of the oscillating circuit is changed in dependence on temperature changes.

The present invention has been developed to resolve these problems. It is an object of the present invention to provide a temperature-compensated piezoelectric oscillator that is easily packaged in an IC and is easily adjusted after its assembly.

These objects are achieved with a temperature-compensated piezoelectric oscillator as claimed in claim 1. Preferred embodiments are subject-matter of the dependent claims.

In the oscillator as claimed in claim 1, the limiter circuit limits the applied power supply voltage fed to the oscillator circuit to a predetermined range of change. Further, when the oscillation frequency of a vibrator varies in response to the ambient temperature, a power supply voltage applied to an oscillator circuit is changed in response to the ambient temperature, and the oscillation frequency is changed in response to the change of the applied power supply voltage. As a result, the oscillation frequency of the entire oscillator is kept within a predetermined range by compensating the frequency-temperature characteristics of the vibrator. Furthermore, since the frequency-temperature characteristics are compensated by changing the applied power supply voltage, the installation of a variable reactance element external to the oscillator circuit is no longer required. This arrangement allows each circuit element of the temperature-compensated piezoelectric oscillator to be easily integrated in CMOS process, and thus IC packaging of the oscillator is easier.

In the embodiment according to claim 2, the limiter circuit limits the applied power supply voltage fed to the oscillator circuit to a voltage lower than the power supply voltage provided to the temperature-compensated piezoelectric oscillator. As a result, the oscillator circuit is much less sensitive to fluctuations in the power supply voltage of the temperature-compensated piezoelectric oscillator. This results in a more stable oscillator circuit.

In the embodiment according to claim 3, the limiter circuit limits the applied power supply voltage to the oscillator circuit to a voltage higher than the oscillation cutoff voltage. As a result, a wider margin of oscillation is provided for a stable temperature-compensated piezoelectric oscillator.

In the embodiment according to claim 4, since compensating data is stored in the data memory means and is read in response to the ambient temperature and the applied power supply voltage is changed according to the compensating data, the applied power supply voltage needed to compensate the frequency-temperature characteristics of the vibrator is easily generated.

In the embodiment according to claim 5, the compensating data is stored in the data memory means and is read, and based on the read compensating data and the ambient temperature, the supply voltage needed to compensate the frequency changes associated with at least one of the linear coefficient A, the quadratic coefficient B and the cubic coefficient C is easily generated.

In the embodiment according to claim 6, only a multiplication coefficient G and an addition constant H constitute the compensating data, thereby greatly reducing the required capacity of the data memory means. Thus, the size of the temperature-compensated piezoelectric oscillator is further reduced.

In the embodiment according to claim 7 or 8, data such as the compensating data is fed from the outside after the manufacturing of the temperature-compensated piezoelectric oscillator. As a result, there is no need for replacement of any internal circuit element, and circuit characteristic differences due to manufacturing variations can be adjusted on an individual basis. Namely, an integrated temperature-compensated piezoelectric oscillator in an IC package results, permitting mass production, reducing manufacturing cost, and facilitating adjustment procedures after assembly.

It may happen that the reference frequency (the characteristic frequency at a reference temperature) of the vibrator used in the temperature-compensated piezoelectric oscillator may deviate from a desired frequency due to manufacturing variations. In the embodiment according to claim 9 or 10, the deviation of the reference frequency is easily compensated based on the frequency setting data associated with the particular vibrator, and thus the accuracy of the oscillation frequency is increased. If the frequency setting data is allowed to be modified after the temperature-compensated piezoelectric oscillator is assembled, the adjustment of the oscillation frequency is easily performed in the mass-produced IC piezoelectric oscillators after they are assembled.

Generally, the oscillator circuit tends to have a narrow oscillation margin and an increased oscillation cutoff voltage at a high temperature. In the embodiment according to claim 11, however, an oscillation margin is assured even at a high temperature since the applied power supply voltage is increased in response to the rise of the ambient temperature.

In the embodiment according to claim 12, the temperature-compensated piezoelectric oscillator is miniaturized and adapted to mass production.

In the embodiment according to claim 13, for example, the size of the temperature-compensated piezoelectric oscillator is reduced, allowing the oscillator to be packaged into a resin mold such as a plastic mold and to be adapted to mass production, resulting in an easy-to-handle temperature-compensated piezoelectric oscillator.

In the embodiment according to claim 14, the size of an entire temperature-compensated piezoelectric oscillator is reduced, allowing the entire oscillator to be housed in a package such as a ceramic package, and to be adapted to mass production, resulting in an-easy-to-handle temperature-compensated piezoelectric oscillator.

Preferred embodiments of the invention will be described in detail below with reference to the drawings, in which:
- Fig. 1: is a block diagram showing a temperature-compensated piezoelectric oscillator according to one embodiment of the present invention.
- Fig. 2: is a diagram showing an example of an oscillator circuit and the connections between the oscillator circuit and its peripheral circuits.
- Fig. 3: is a diagram showing an example of the frequency-temperature characteristics of a piezoelectric vibrator such as an AT cut crystal.
- Fig. 4: is a diagram showing an example of the frequency-power supply voltage characteristics of an oscillator circuit.
- Fig. 5: is a block diagram showing a example of data stored in a data memory circuit.
- Fig. 6: is a block diagram showing an example of a function generator circuit.
- Fig. 7: is a diagram showing an example of a D/A converter.
- Fig. 8: is diagrams showing circuits of variable gain amplifiers.
- Fig. 9: is a diagram showing an example of the output voltage-temperature characteristics of a temperature sensor circuit.
- Fig. 10: is a diagram showing an example of the output voltage-temperature characteristics of a function generator circuit.
- Fig. 11: is a diagram showing an example of a temperature function supply voltage generator circuit.
- Fig. 12: is a diagram showing an example of the output voltage-temperature characteristics of a temperature function supply voltage generator circuit.
- Fig. 13: is a diagram showing an example of the frequency-temperature characteristics of a temperature-compensated piezoelectric oscillator in response to modified gain setting data.
- Fig. 14: is a diagram showing an example of the frequency-temperature characteristics of a temperature-compensated piezoelectric oscillator with and without temperature compensation.
- Fig. 15: is a perspective view showing an example of the construction of a temperature-compensated piezoelectric oscillator.
- Fig. 16(a) and (b): are block diagrams showing other examples of a function generator circuit.
- Fig. 17: is a diagram showing an example of the output voltage-temperature characteristics of the function generator circuit of Fig. 16.
- Fig. 18: is a block diagram of a temperature-compensated piezoelectric oscillator according to another embodiment of the present invention.
- Fig. 19: is a block diagram showing an example of data stored in a data memory circuit for use in the temperature-compensated piezoelectric oscillator of Fig. 18.
- Fig. 20: is a block diagram showing an example of the frequency-temperature characteristics of the temperature-compensated piezoelectric oscillator of Fig. 18.
- Fig. 21: is a diagram showing an example of the frequency-temperature characteristics of the temperature-compensated piezoelectric oscillator of Fig. 18 with temperature compensation.
- Fig. 22: is a diagram showing an example of a prior art analog temperature-compensated piezoelectric oscillator.
- Fig. 23: is a perspective view showing an example of the construction of the temperature-compensated piezoelectric oscillator of Fig. 22.
- Fig. 24: is a block diagram showing an example of a prior art digital temperature-compensated piezoelectric oscillator.
- Fig. 25: is a diagram showing the oscillator circuit of the temperature-compensated piezoelectric oscillator of Fig. 24 and the connections between the oscillator circuit and its peripheral circuits.
- Fig. 26: is a perspective view showing an example of the construction of the temperature-compensated piezoelectric oscillator of Fig. 24.

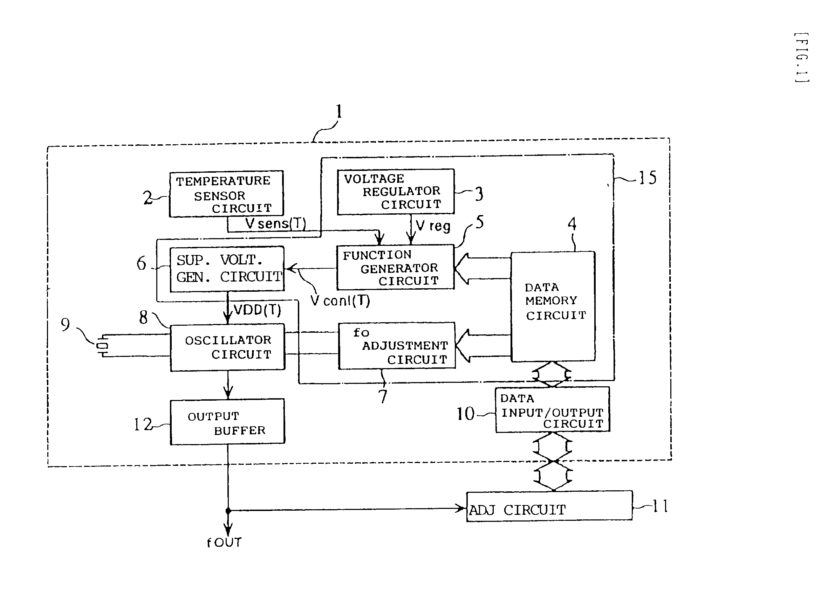

Fig. 1 is a block diagram showing a temperature-compensated piezoelectric oscillator 1 according to a first embodiment, comprising a temperature sensor circuit 2, an oscillator circuit 8, a piezoelectric vibrator 9, an output buffer 12, a variable power supply circuit 15, and a data input/output circuit (data input means) 10. The oscillator 1 is designed to connect to an external f_{O} temperature characteristic adjustment circuit 11 during an adjustment step after assembly.

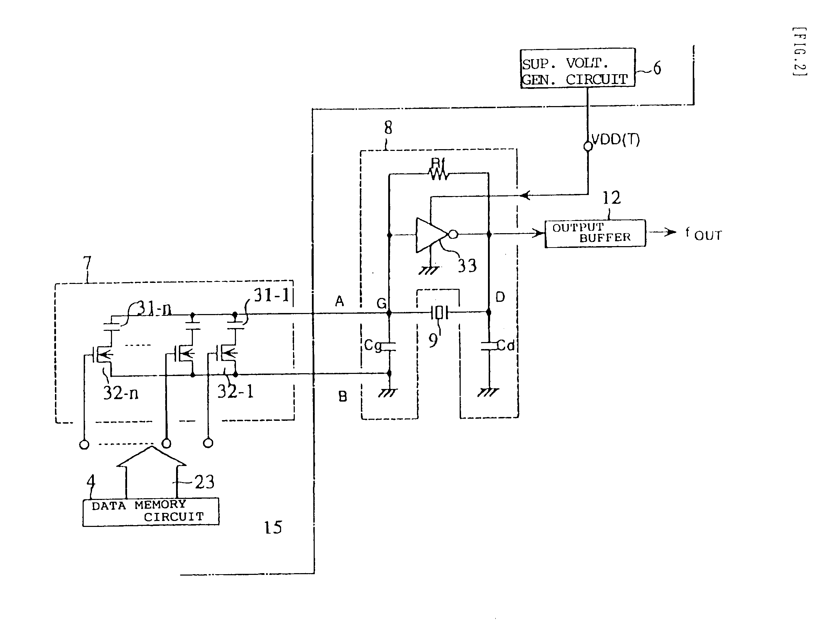

As shown in Fig. 2, the electrodes at both ends of the vibrator 9 are connected to junction G and junction D of the oscillator circuit 8, which are connected to the gate and the drain of a CMOS inverter 33, respectively. The vibrator 9 is constructed of a commonly used AT cut crystal and has a frequency-temperature characteristic such as that illustrated by curve (a) in Fig. 3. The frequency-temperature characteristic may be approximated by the following polynomial,${\text{Δf/f}}_{\text{O}} {\text{= A(T-25) + B(T-25)}}^{\text{2}} {\text{+ C(T-25)}}^{\text{3}}$ where T represents the ambient temperature, f_{O} represents an oscillation frequency (hereinafter referred to as "reference frequency") at 25°C (hereinafter referred to as "reference temperature"), Δf represents the frequency deviation f(T) - f_{O}, and Δf/f_{O} represents a normalized frequency deviation.

To keep the normalized frequency deviation within a tolerance of ±2.5 ppm (hereinafter referred to as "target range") over a temperature range from -10 to +60 °C, as shown by dotted box (b) in Fig. 3, components of the oscillator 1, to be described below, is set to compensate the frequency deviation Δf/f_{O} arising from the linear coefficient A of the equation (1), that is, portion of the variation of frequency deviation Δf/f_{O} that decreases with increasing ambient temperature T.

As shown in Fig. 2, the oscillator circuit 8 comprises CMOS inverter 33 with feedback resistor Rf between drain and gate, a capacitor Cg that determines the reactance of the gate (input) side of the CMOS inverter 33, and a capacitor Cd that determines the reactance of the drain (output) side. Also, as shown in Fig. 1 and Fig. 2, CMOS inverter 33 is connected to a temperature function supply voltage generator circuit 6 of the variable power supply circuit 15 that provides a variable supply voltage VDD(T) to the CMOS inverter 33. The f_{O} adjustment circuit 7 used for adjusting the reference frequency f_{O} is connected to junction G. Output buffer 12, used to increase output drive and to isolate oscillator circuit 8, is connected to junction D.

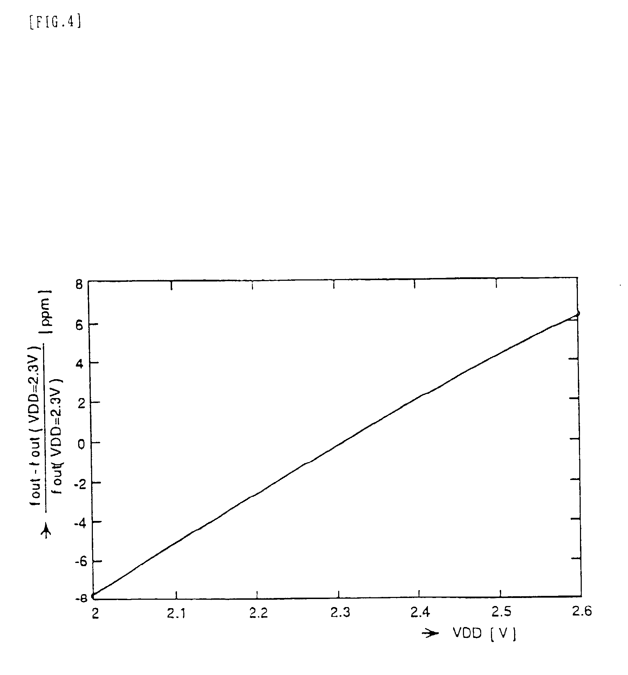

By changing the power supply voltage VDD(T) to oscillator circuit 8, a voltage-dependent reactance component such as the capacitance between terminals of CMOS inverter 33 can be changed, thereby changing the reactance of the entire oscillator circuit 8. As a result, oscillator circuit 8 is provided with a frequency-temperature characteristic such as that shown in Fig. 4, wherein the normalized frequency deviation Δf/f_{O} increases with increasing power supply voltage VDD(T), namely, the normalized frequency deviation is proportional to the power supply voltage VDD(T). Frequency compensation can be provided by taking advantage of this frequency characteristic of oscillator circuit 8. More specifically, oscillator 1 can provide temperature compensation by raising the power supply voltage of oscillator circuit 8 in proportion to the ambient temperature T, thereby compensating for the rightward downwardly inclined portion of the normalized frequency deviation Δf/f_{O} of vibrator 9.

Incidentally, it is to be noted that there are three different types of normalized frequency deviation. A first type (the one to be compensated) is the normalized frequency deviation Δf/f_{O} of the vibrator itself. The second type (the compensating one) is that of the oscillator circuit as it would be if not influenced by deviations in the vibrator. The third type (the compensated one) is that ([fout-fout(T=25°C)]/fout(T=25°C)) of the actual oscillation frequency fout of the entire oscillator circuit, i.e., that of oscillator 1 as a whole. With this understanding, the normalized frequency deviation of the oscillator circuit, as the term is used in the preceding paragraph, represents the second type of normalized deviation: the oscillation frequency of the oscillator circuit that would be observed if the characteristic frequency of the vibrator were constant (temperature independent).

Variable power supply circuit 15, shown in Fig. 1, comprises voltage regulator circuit 3, data memory circuit 4, function generator circuit 5, supply voltage generator circuit 6, and f_{O} adjustment circuit 7. Voltage regulator circuit 3 generates reference voltage Vreg for function generator circuit 5, providing a supply voltage that remains relatively unaffected by voltage variations in the power supply voltage of oscillator 1. The power supply for oscillator 1 is conventional and well understood in the art; therefore, it is not shown in the figures to simplify the illustrations.

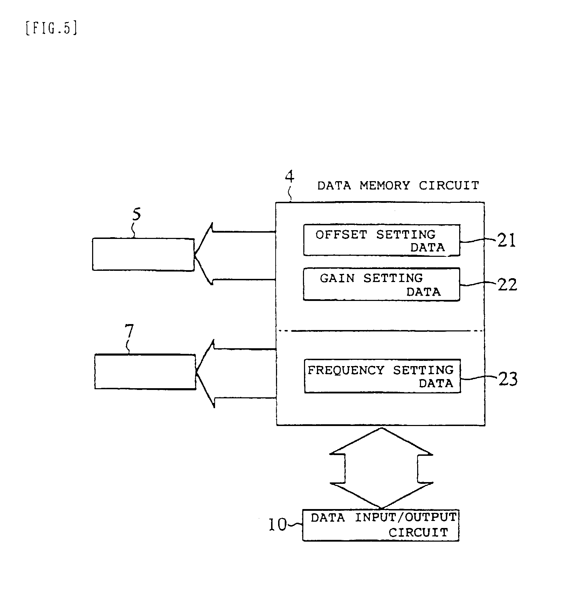

The data memory circuit 4 may be constructed of non-volatile semiconductor memory such as that provided by an EEPROM and, after assembly of the oscillator 1, adjustment circuit 11 external to oscillator 1 is connected to the data memory circuit 4 via data input/output circuit 10, as shown in Fig. 1. In this manner, compensating data may be written and stored in data memory circuit 4. As shown in Fig. 5, this data comprises offset setting data 21 (addition constant) for adjusting the offset for compensation of frequency-temperature characteristics of vibrator 9, gain setting data 22 (multiplication coefficient) for adjusting the slope of compensation, and frequency setting data 23 for adjusting the reference frequency f_{O}.

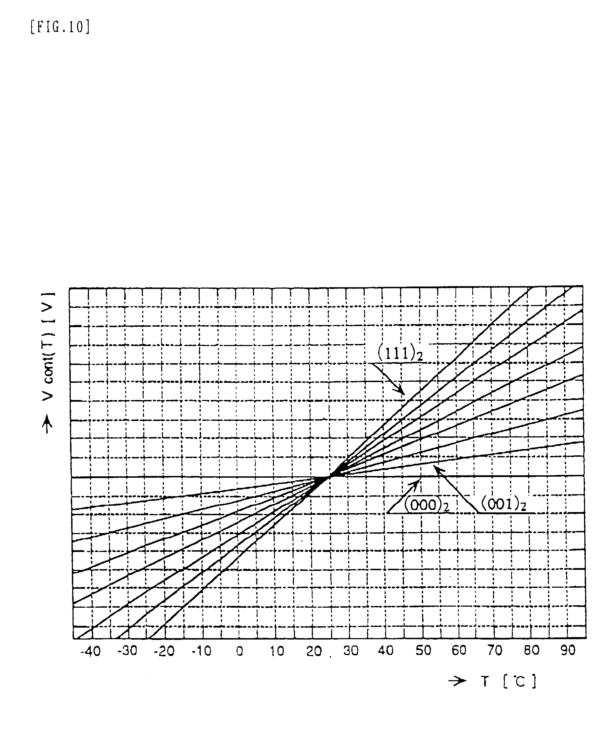

Gain setting data 22 determines the slope of control voltage Vcont(T), to be described later, with respect to changes in ambient temperature T (refer to Fig. 10). Gain setting data may be expressed in three bits, representing any value from (000)₂ to (111)₂, for example. Offset setting data 21 compensates for any shift in voltage at the reference temperature that may occur as the gain or the slope of control voltage Vcont(T) is adjusted. Offset setting data may be expressed in five bits, for example. Frequency setting data 23 compensates for a shift in the oscillation frequency of oscillator circuit 8 at the reference temperature with respect to the reference frequency f_{O} to be set during the adjustment step, and is expressed by n bits, say n = 8, where n is equal to the number of switch elements 32-1 to 32-n in f_{O} adjustment circuit 7, shown in Fig. 2.

The values for setting data 21, 22, and 23, stored in data memory circuit 4, are established to match the frequency-temperature characteristics of each vibrator 9 used in a respective oscillator 1 to compensate for variations from vibrator to vibrator by means of adjustment circuit 11. After the values for setting data 21, 22 and 23 are have been established, that is, after the adjustment procedure following assembly is completed, adjustment circuit 11 is electrically disconnected from the oscillator 1.

The f_{O} adjustment circuit 7, connected to junction G of oscillator circuit 8 as shown in Fig. 2, compensates for manufacturing variations in the reference frequency f_{O} of vibrator 9, by changing the capacitance at the gate side of CMOS inverter 33. This change in capacitance changes the reactance of oscillator circuit 8, thereby adjusting reference frequency f_{O} of the oscillator circuit 8. As shown, f_{O} adjustment circuit 7 comprises a plurality of capacitors 31-1 to 31-n, each capacitor connected in series with a respective one of a plurality of switches 32-1 to 32-n. The ON/OFF states of switches 32-1 to 32-n are controlled by frequency setting data 23 in data memory circuit 4. Specifically, reference frequency f_{O} of oscillator circuit 8 is adjusted by changing the capacitance between the gate of the oscillator circuit 8 and ground (between nodes A and B shown in Fig. 2) by switching on one or more of the plurality of capacitors 31-1 to 31-n in accordance with the value of frequency setting data 23.

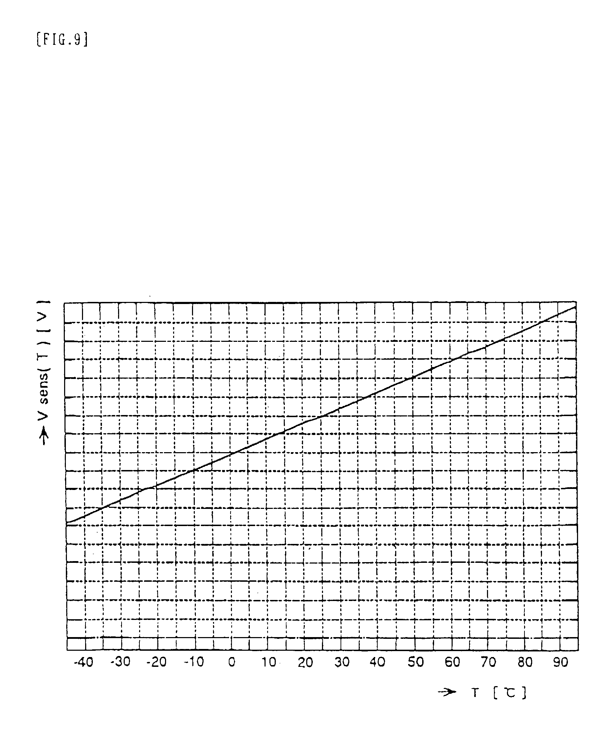

Temperature sensor circuit 2 comprises a temperature sensor that makes use of the forward voltage characteristic of a semiconductor P-N junction, and is designed to generate a temperature-dependent voltage Vsens(T) as a function of ambient temperature T. The temperature-dependent voltage Vsens(T) varies linearly with respect to ambient temperature T as shown in Fig. 9.

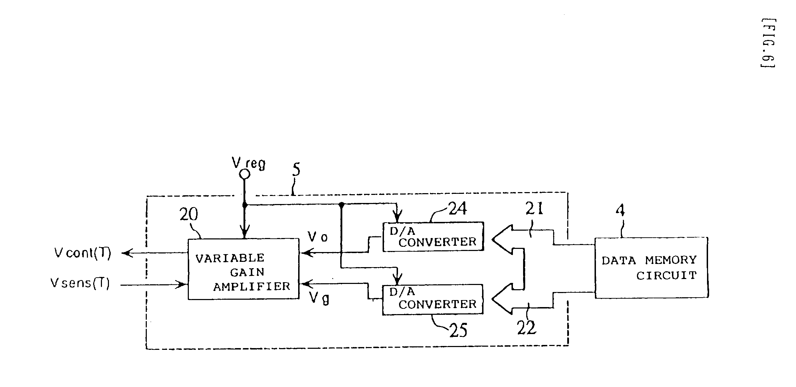

Function generator circuit 5, as shown in Fig. 6, comprises two D/A converters 24 and 25, and a variable gain amplifier 20. Function generator circuit 5 generates control voltage Vcont(T) in response to reference voltage Vreg from the voltage regulator 3, temperature-dependent voltage Vsens(T) from temperature sensor circuit 2, and offset setting data 21 and gain setting data 22 from data memory circuit 4. Control voltage Vcont(T) is passed to supply voltage generator circuit 6.

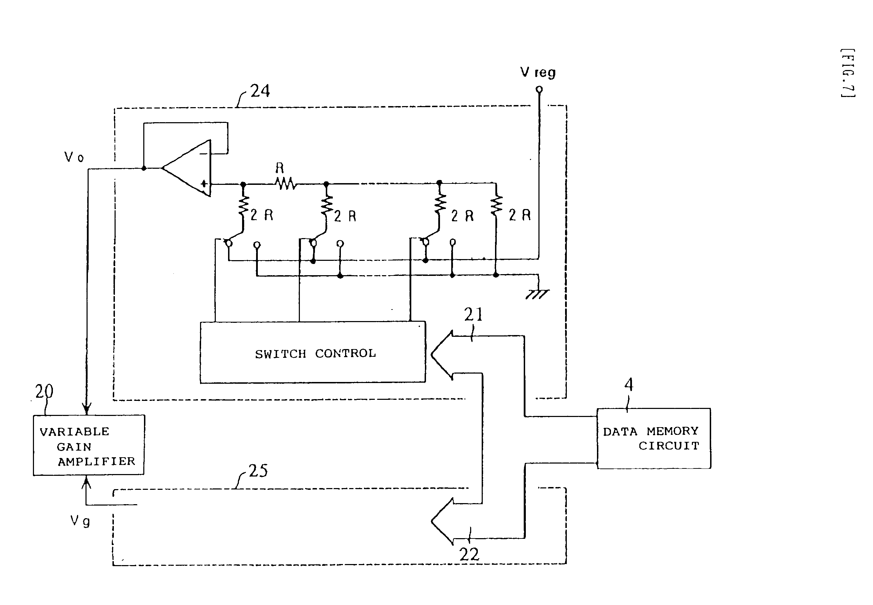

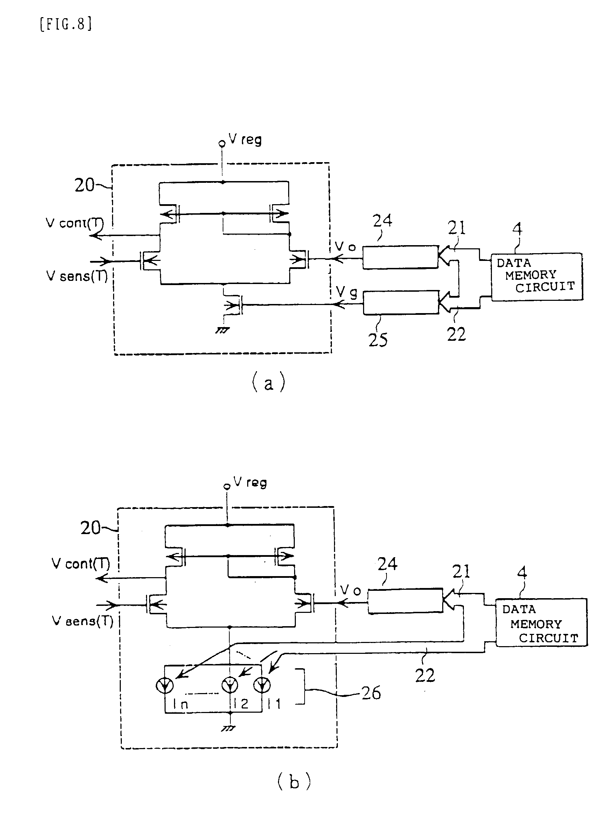

D/A converters 24 and 25, implemented as R-2R ladder-resistor-type D/A converters as shown in Fig. 7, convert offset setting data 21 and gain setting data 22 stored in data memory circuit 4 into an analog offset setting voltage Vo and an analog gain setting voltage Vg, respectively. These two analog voltages are passed to variable gain amplifier 20 which, as shown in Fig. 8(a), is a differential amplifier driven by reference voltage Vreg from the voltage regulator circuit 3. The slope of Vcont(T) is controlled by the gain of variable gain amplifier 20 which in turn is controlled by gain setting voltage Vg. The slope of Vcont(T) is further controlled by the slope of the temperature-dependent voltage Vsens(T) from temperature sensor circuit 2. The voltage Vcont(T) is set to a predefined voltage at the reference temperature by adjusting the difference between temperature-dependent voltage Vsens(T) and offset setting voltage Vo. Control voltage Vcont(T) is passed to supply voltage generator circuit 6.

As discussed above and as shown in Fig. 9, the temperature-dependent voltage Vsens(T) varies linearly with respect to ambient temperature T. Variable gain amplifier 20 also provides control voltage Vcont(T) which varies linearly with respect to ambient temperature T. By adjusting the gain of amplifier 20 via voltage Vg, the slope of control voltage Vcont(T) as a function of ambient temperature T can be modified. Similarly, by adjusting the offset of amplifier 20 via voltage Vo, the value of control voltage Vcont(T) at a reference temperature can be modified. As discussed above, voltages Vg and Vo are generated in response to gain setting data and offset setting data stored in data memory circuit 4, respectively. Thus, the slope and intercept of control voltage Vcont(T) as a function of ambient temperature T is controlled by setting data stored in data memory circuit 4. For example, as shown in Fig. 10, when gain setting data 22 has a value (000)₂, the slope of control voltage Vcont(T) with respect to temperature is small. As the value of gain setting data 22 increases, the slope of control voltage Vcont(T) increases.

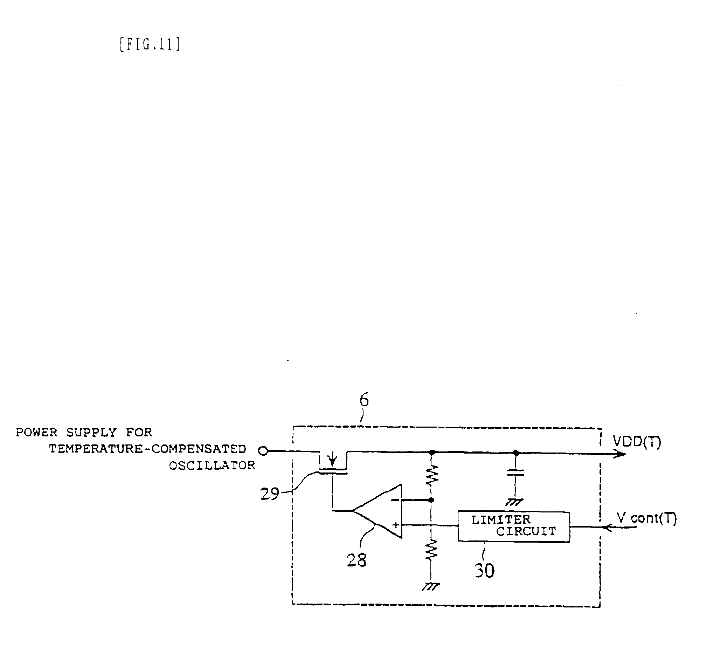

The supply voltage generator circuit 6, comprising a differential amplifier 28, a control transistor 29, and a limiter circuit 30 as shown in Fig. 11, generates power supply voltage VDD(T) which is proportional to control voltage Vcont(T). Limiter circuit 30 keeps power supply voltage VDD(T) within a predetermined range of voltages. By limiting the range of power supply voltage VDD(T), limiter circuit 30 prevents a deterioration of the frequency-power supply characteristic of oscillator circuit 8 that would otherwise occur when the power supply voltage VDD(T) rises to a level near the power supply voltage of oscillator 1, and also prevents a cessation of oscillation of oscillator circuit 8 that would otherwise occur when power supply voltage VDD(T) falls to a level at or below the oscillation cutoff voltage.

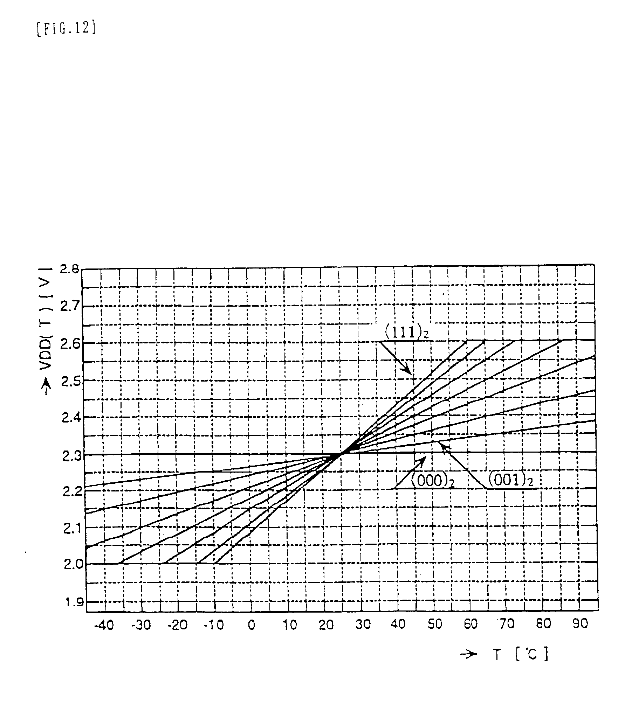

Unlike the temperature characteristics of the control voltage Vcont(T) shown in Fig. 10, the power supply voltage VDD(T) is bounded by upper and lower voltages as shown in Fig. 12. Generally, the oscillator circuit 8 tends to have a narrower oscillation margin and a raised oscillation cutoff voltage at higher temperatures. By varying the power supply voltage VDD(T) in proportion to the control voltage Vcont(T) within the predetermined range, the power supply voltage VDD(T) is set to a higher level at higher temperatures, thereby increasing the oscillation margin of the oscillator circuit 8 at higher temperatures.

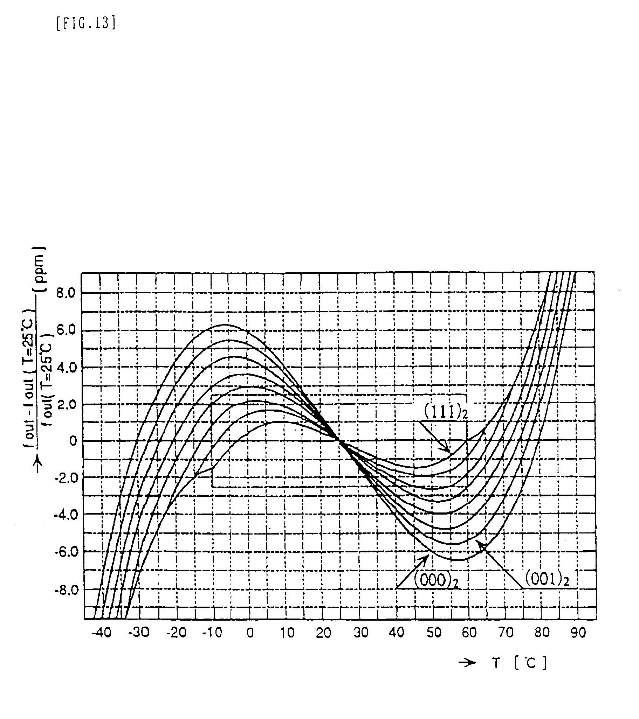

As already described, during adjustment of the oscillator 1 after its assembly, the offset setting data 21, the gain setting data 22, and the frequency setting data 23 are stored in data memory circuit 4, as shown in Fig. 5, by means of f_{O} temperature characteristic adjustment circuit 11. For a given vibrator 9, the normalized frequency deviation [fout-fout(T=25°C)]/fout(T=25°C) of oscillator 1 will vary as a function of gain setting data 22 in a manner similar to that shown in Fig. 13. The exact temperature characteristic also depends on the combination of the temperature characteristic of the power supply voltage VDD(T), described above with reference to Fig. 12, and the frequency characteristic of the oscillator circuit 8, described above with reference to Fig. 4. Namely, by modifying the value of the gain setting data 22, the frequency-temperature characteristic of the oscillator 1 is changed.

Therefore, it is possible to compensate for a range of the frequency-temperature characteristics caused by variations among individual vibrators 9 by selecting an appropriate value for the gain setting data 22. For example, if vibrator 9 has the normalized frequency deviation characteristic shown in Fig. 3, power supply voltage VDD(T) has the temperature-gain characteristics shown in Fig.12, and oscillator circuit 8 has the frequency-voltage characteristic shown in Fig. 4, then oscillator 1 has the frequency-temperature characteristic of curve (000)₂ shown in Fig. 13 when gain setting data 22 has a value of (000)₂. Further, in this example, oscillator 1 has the frequency-temperature characteristics of curves (001)₂ and (111)₂ in response to gain setting data having values equal to (001)₂ and (111)₂, respectively.

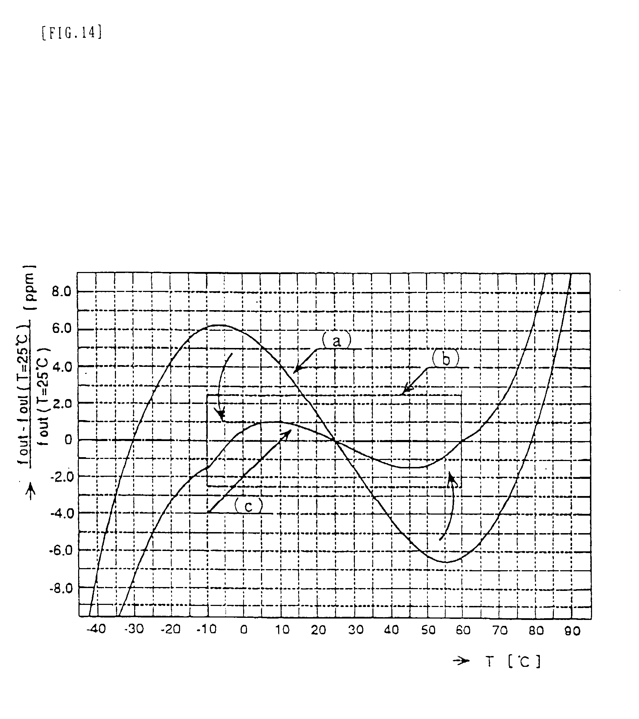

Referring now to Fig. 14, curve (a) represents the frequency-temperature characteristics of oscillator 1 without temperature compensation. This characteristic corresponds to the normalized frequency deviation characteristic of vibrator 9, shown in Fig. 3. A power supply voltage VDD(T) having the temperature characteristic of line (111)₂ shown in Fig. 12 is fed to the oscillator circuit 8 as a function of the ambient temperature T by setting the value of gain setting data 22 equal to (111)₂. The oscillator circuit 8 changes its oscillation frequency according to the frequency-voltage characteristics shown in Fig. 4, thereby compensating the frequency-temperature characteristics of the vibrator 9, represented by curve (a) in Fig. 14. As a result, the oscillator 1 exhibits the frequency-temperature characteristic represented by curve (c) in Fig. 14, which is within the target range designated (b). As mentioned above, box (b) represents a target range of ±2.5 ppm over a temperature range from -10 to +60 °C. It can now be appreciated that the same method may be used to provide temperature compensation for another oscillator 1 incorporating a vibrator 9 having a frequency-temperature characteristic different from that of the vibrator 9, described above and illustrated in Fig. 3.

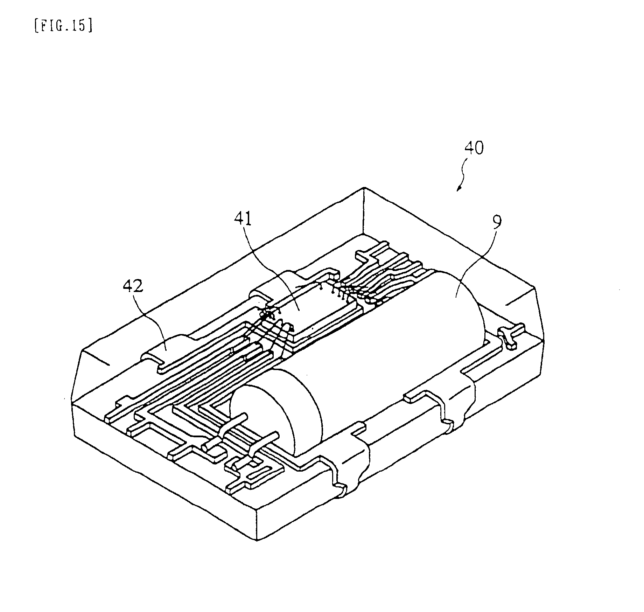

All of the above-described components in the oscillator 1, except for vibrator 9, may be constructed using elements that are easy to integrate into an IC structure; therefore, all of these components may be implemented in a single temperature-compensated piezoelectric oscillator IC 41. Furthermore, the IC 41 together with the vibrator 9 can be mounted on a lead frame 42 as shown in Fig. 15 and then packaged integrally into a plastic mold 40. Such packaging is attractive because the size of the entire oscillator 1 can be reduced, and the ease of manufacturing and handling can be enhanced. Reliability is improved as a result of IC structure, and mass production helps reduce the manufacturing cost.

Since the frequency-temperature characteristics of oscillator 1 are compensated by changing the power supply voltage VDD(T), an external variable reactance element, as required in the prior art, is no longer required. Therefore, all circuit elements in the oscillator 1 may be incorporated into a single IC structure which, for example, is easy to manufacture in a CMOS process,.

Temperature compensation may also be provided for oscillator 1 by a single set of data stored in the data memory circuit 4, provided the single set of data matches the characteristic of the vibrator 9 in use. More particularly, the single set of data comprises gain setting data 22 (a multiplication coefficient) and offset setting data 21 (an addition constant), both constituting the compensating data, and frequency setting data 23. This single set of data may be stored in 16 bits, for example, where the gain setting data 22, offset setting data 21 and frequency setting data 23 are represented by 3 bits, 5 bits, and 8 bits, respectively. Sixteen bits of storage is substantially smaller than that required in the prior art digital oscillator 200 shown in Fig. 24, therefore, miniaturization and cost reduction of IC 41 are promoted.

As explained above, data such as the compensating data is entered into the oscillator 1 from an external source after oscillator 1 is manufactured; therefore, differences in circuit characteristics due to manufacturing variations can be individually adjusted without replacement of internal circuit elements. Because of this feature, the IC 41 can be mass produced. Mass production and simplified adjustment procedures both help reduce manufacturing costs.

As described above, the limiter circuit 30 limits the power supply voltage of the oscillator circuit 8 to the predetermined range. By limiting the power supply voltage of the oscillator circuit 8 to a maximum predetermined voltage level that is lower than the power supply voltage of oscillator 1, the oscillator 1 becomes more reliable and less sensitive to variations in the power supply voltage of the oscillator 1. By limiting the power supply voltage of the oscillator circuit 8 to a minimum predetermined voltage level that is higher than the oscillation cutoff voltage, oscillator 1 becomes more stable and less likely to stop oscillating because of low voltage conditions.

In the embodiments discussed above, gain adjustment is achieved using D/A converter 25, shown in Fig. 7 and Fig. 8(a), which is an R-2R ladder-resistor-type converter. An alternative gain adjusting technique, shown in Fig. 8(b), utilizes current sources 26-11 to 26-In. By switching each of these current sources ON/OFF as desired, current may be controlled digitally.

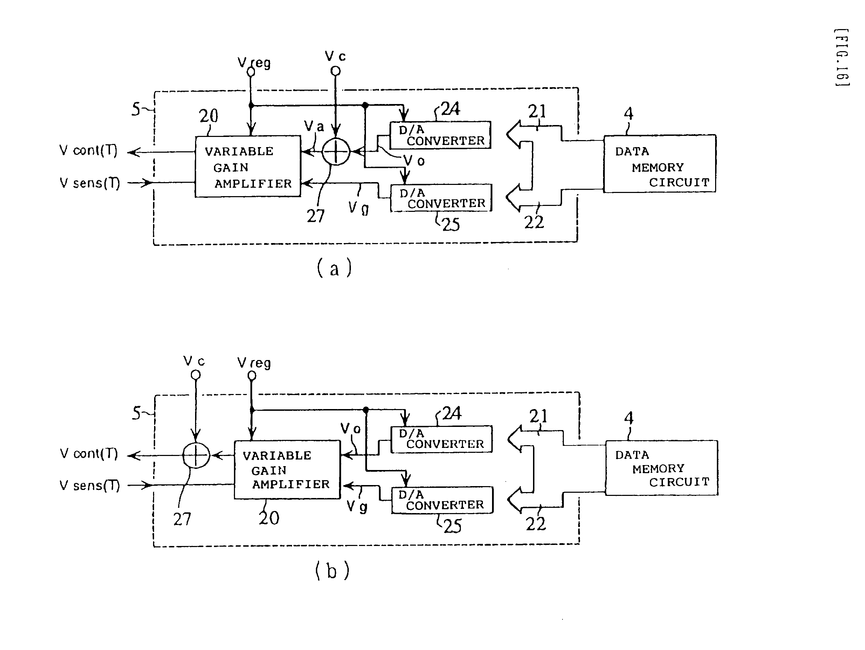

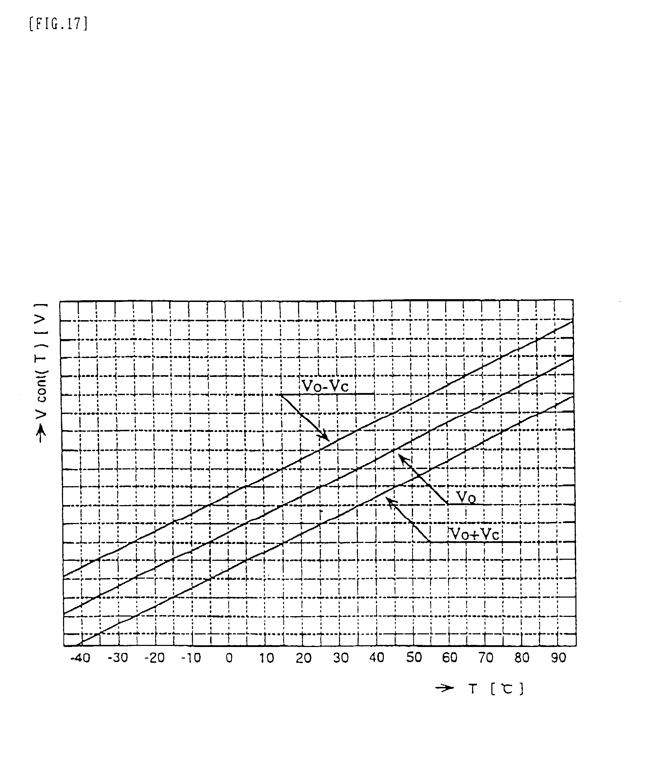

As an alternative to the structure shown in Fig. 6, the function generator 5 may be implemented as shown in Fig. 16(a) using a circuit that performs frequency control in response to an external control voltage Vc provided by a source outside the oscillator 1. Such a circuit may, for example, be implemented by an adder 27. Referring to Fig. 16(a), the adder 27 changes the control voltage Vcont(T) as shown in Fig. 17 by additively and subtractively combining the control voltage Vc with the offset setting voltage Vo for the variable gain amplifier 20. In this way the frequency-temperature characteristic of the oscillator circuit 8 can be shifted upward or downward in level. Since in this arrangement the reference frequency f_{O} of the oscillator circuit 8 is adjusted by the external control voltage Vc, the f_{O} adjustment circuit 7 as shown in Fig. 1, 2 and 18 is not required. The adder 27, if connected to the output side of the variable gain amplifier 20 as shown in Fig. 16(b), provides an effect substantially the same as described above.

In one embodiment of the oscillator 1, the variable power supply circuit 15 is designed to compensate for only that part of the normalized frequency deviation Δf/f_{O} of vibrator 9 represented by the linear coefficient A in polynomial (1), discussed above. A more precise compensation may be achieved across a wider range of the ambient temperature T in other embodiments by including compensation for that part of the frequency deviation Δf/f_{O} represented by the quadratic coefficient B and, optionally, the cubic coefficient C.

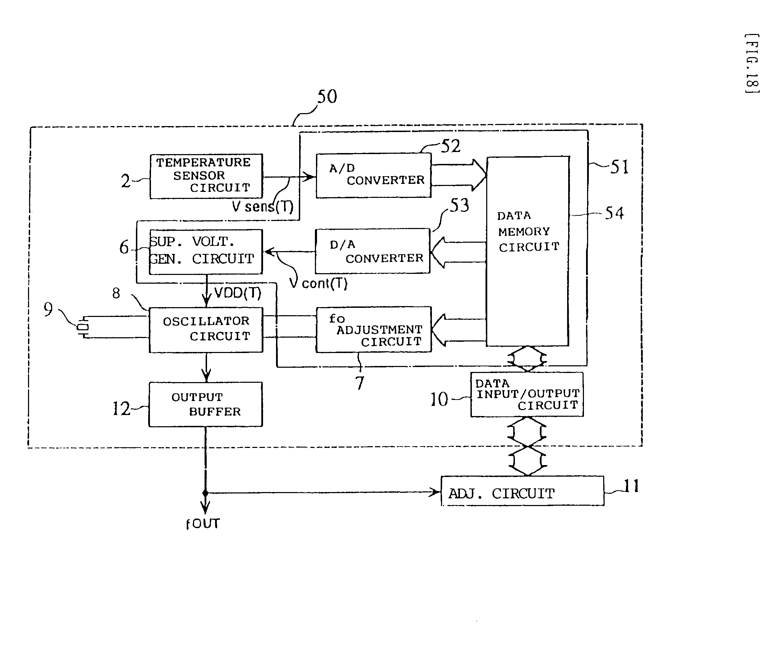

Fig. 18 is a block diagram of a temperature-compensated piezoelectric oscillator 50, which represents another embodiment of the present invention that is capable of providing compensation for the linear, quadratic and/or cubic coefficients in polynomial (1). In the oscillator 50, a variable power supply circuit 51 comprises some of the features of variable power supply circuit 15 shown in Fig. 1 and some of the features of the prior art oscillator 200 shown in Fig. 24.

Specifically, the variable power supply circuit 51, as shown in Fig. 18, comprises an A/D converter 52 for converting an analog temperature-dependent voltage Vsens(T) from a temperature sensor circuit 2 into digital temperature data, a data memory circuit 54 for providing digital compensating data in response to the digital temperature data, a D/A converter 53 for converting the digital compensating data into an analog control voltage Vcont(T), and a temperature function supply voltage generator circuit 6 and an f_{O} adjustment circuit 7, both of which are identical to respective circuits in the variable power supply circuit 15 shown in Fig. 1.

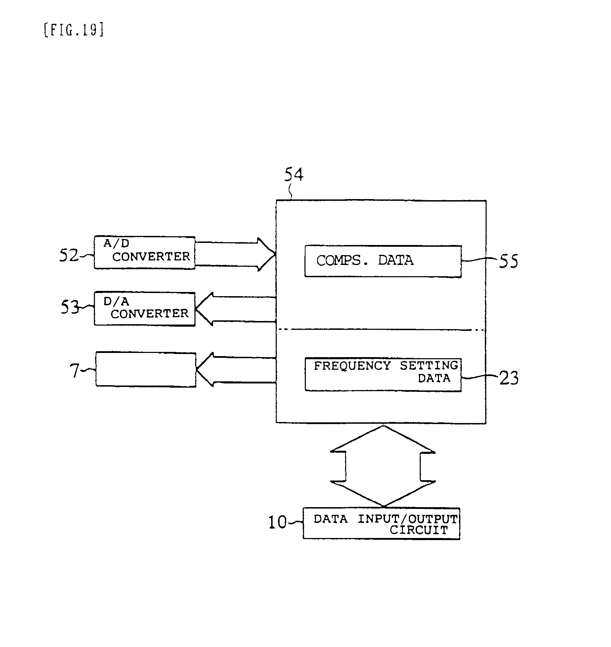

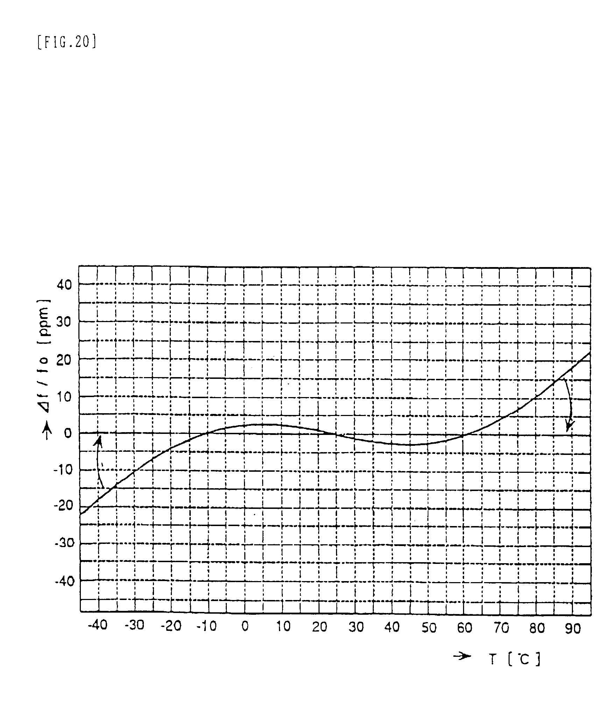

The data memory circuit 54, as shown in Fig. 19, stores temperature characteristic compensating data 55 for compensating the frequency-temperature characteristics of the vibrator 9 and stores frequency setting data 23 that is identical to that stored in the data memory circuit 4 in Fig. 5. As will be appreciated, an adder (like 27 in Fig. 16(b)) may be provided between D/A converter 53 and supply voltage generator circuit 6 in order to control f_{O} by means of a control voltage Vc as explained above for the first embodiment. In such case adjustment circuit 7 and frequency setting data in data memory 54 are not required. The compensating data 55 varies as a function of the ambient temperature T and is arranged in memory according to respective digital temperature data received from the A/D converter 52. That is, compensating data that corresponds to a respective temperature is stored in memory circuit 54 at an address corresponding to that respective temperature so that a sensed temperature, as received from the temperature sensor circuit 2 through A/D converter 52, may be used to determine the address from which the compensating data for that sensed temperature can be read. The compensating data stored at a particular address in memory circuit 54 provides the appropriate value of the control voltage Vcont(T) for a respective ambient temperature T corresponding to that address. The appropriate value of Vcont(T) is that voltage required to compensate for the frequency-temperature characteristic of the vibrator 9 in the oscillator 50. For example, as shown in Fig. 20, the normalized frequency deviation Δf/f_{O} of vibrator 9 is compensated at each ambient temperature (in the directions of the arrows in the figure) so as to obtain for oscillator 50 a compensated normalized frequency deviation [fout- fout(T=25°C)]/fout(T=25°C) that is close to zero across the desired temperature range. The time and procedure for storing these data 55 and 23 into the data memory circuit 54 are the same as those described above for storing the data into data memory circuit 4 of oscillator 1. In other words, after assembly of the oscillator 50 the required data are established by measurement using adjustment circuit 11 and input to the data memory circuit 54.

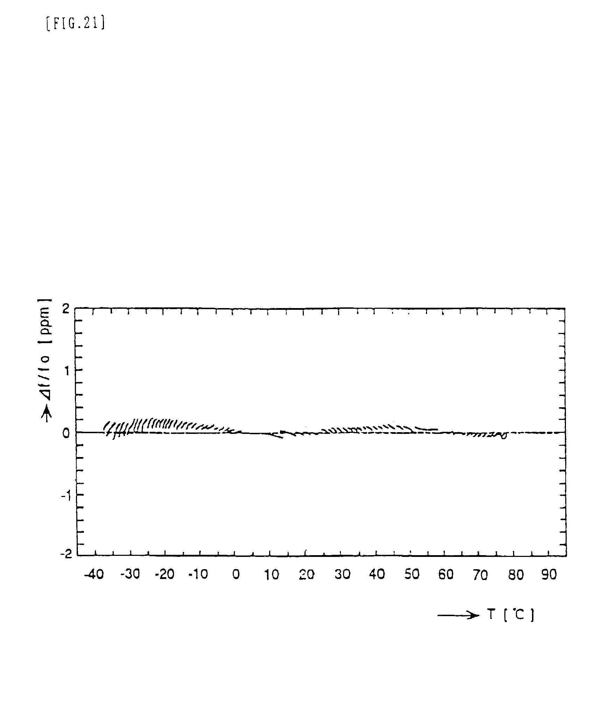

In the variable power supply circuit 51, the compensating data is read from the data memory circuit 54 in response to the temperature-dependent voltage Vsens(T) provided by the temperature sensor circuit 2, the digital compensating data is converted into the analog control voltage Vcont(T) by the D/A converter 53, and the power supply voltage VDD(T) is varied by the supply voltage generator circuit 6 in response to the control voltage Vcont(T). The supply voltage generator circuit 6 changes the reactance of the oscillator circuit 19 to compensate for the frequency-temperature characteristics of the vibrator 9; thus, the frequency-temperature characteristics of the oscillator 50 are varied so as to achieve temperature compensation. For example, the frequency-temperature characteristic of the vibrator 9 shown in Fig. 20, having a normalized frequency deviation Δf/f_{O} of approximately ± 18 ppm across a temperature range from -40°C to +80°C, is compensated to obtain for oscillator 50 an overall frequency-temperature characteristic as shown in Fig. 21, having a normalized frequency deviation of approximately ±0.3 ppm across the same temperature range.

The oscillator 50 is able to obtain a more precise compensation across a wider range of ambient temperature T than is obtained in the oscillator 1 because the compensation provided in oscillator 50 accounts for the normalized frequency deviation Δf/f_{O} associated with the quadratic coefficient B and the cubic coefficient C of polynomial (1) in addition to the deviation associated with the linear coefficient A of the vibrator 9.

The present invention is not limited to the above-described embodiments, but may be embodied in many forms.

For example, the data memory circuits 4 and 54 may be implemented by memory circuits of the electrically erasable type, the ultraviolet erasable type, the fuse type, or the like, in addition to the semiconductor type such as the EEPROM described above.

In another embodiment, if the offset setting data 21 in the data memory circuit 4 and the compensating data 55 in the data memory circuit 54 are established to account for the shift in the reference frequency f_{O} due to variations among individual vibrators 9, then the frequency setting data 23 and the f_{O} adjustment circuit 7 are not needed and may be omitted.

Alternatively, in yet another embodiment, the f_{O} adjustment circuit 7 may be connected to the drain of the CMOS inverter 33 rather than to the gate as discussed above and shown in Fig. 2.

Preferably, a temperature sensor for use in the temperature sensor circuit 2 will have a substantially linear slope with respect to temperature. Some examples of suitable sensors include devices which measure temperature using the threshold voltage of a semiconductor, the forward voltage of a P-N junction or the resistance of a thermistor.

Both oscillator 1 and oscillator 50 may be housed entirely in a ceramic package rather than the plastic mold 40 discussed above. The ceramic package offers the same advantages of miniaturization and mass production as that provided by the plastic mold.

The examples and techniques discussed above are described by way of example only and do not represent limitations on the present invention, the scope of which is set forth in the following claims.

## Claims

1. A temperature-compensated piezoelectric oscillator comprising
a piezoelectric vibrator (9) having frequency-temperature characteristics,
an oscillator circuit (8) for driving the vibrator (9) and for changing the oscillation frequency in response to a power supply voltage (VDD(T)) applied to the oscillator circuit,
a temperature sensor circuit (2) for sensing the ambient temperature of the vibrator (9), and
a variable power supply circuit (15; 51) responsive to said temperature sensor circuit for generating said power supply voltage so as to change, in response to ambient temperature changes, the oscillation frequency of said oscillator circuit (8) to compensate the frequency-temperature characteristics of said vibrator (9),
**characterized in that**
the variable power supply circuit (15; 51) comprises a limiter circuit (30) that limits the range of said power supply voltage (VDD(T)).

2. The oscillator according to claim 1, wherein the upper limit of said range is set to a voltage lower than the power supply voltage to the temperature-compensated piezoelectric oscillator (1; 50) itself.

3. The oscillator according to claim 1 or 2, wherein the lower limit of said range is set to a voltage higher than an oscillation cutoff voltage of the oscillator circuit (8).

4. The oscillator according to claim 1, 2, or 3, wherein the variable power supply circuit (51) comprises data memory means (54) for storing for a plurality of different ambient temperatures respective compensating data, and means (52; 53) for reading from said data memory means compensating data corresponding to the ambient temperature sensed by said temperature sensor circuit (2), wherein the variable power supply circuit is adapted to change said power supply voltage (VDD(T)) in response to the compensating data read from the data memory means.

5. The oscillator according to claim 1, 2 or 3, wherein
the frequency-temperature characteristic of said vibrator (9) is approximated by a function${\text{f(T) = A(T-25) + B(T-25)}}^{\text{2}} {\text{+C(T-25)}}^{\text{3}}$
wherein T represents the ambient temperature T, A is a linear coefficient, B is a quadratic coefficient and C is a cubic coefficient,
the variable power supply circuit (15) comprises data memory means (4) for storing compensating data for compensating frequency changes corresponding to at least one of the three terms of the function f(T), and
the variable power supply circuit generates said power supply voltage (VDD(T)) based on the compensating data read from the data memory means and the ambient temperature sensed by said temperature sensor circuit (2).

6. The oscillator according to claim 5, wherein said compensating data includes a multiplication coefficient G and an addition constant H, and
the variable power supply circuit (15) is adapted to generate said power supply voltage (VDD(T)) corresponding to a linear function V(T) = G(T) + H.

7. The oscillator according to claim 6, wherein said variable power supply circuit (15) includes variable gain and variable offset amplifier means (20) having an input terminal connected to said temperature sensor circuit (2), a gain control input terminal adapted to receive a gain control voltage (Vg) representing said multiplication coefficient, and an offset control input terminal adapted to receive an offset control voltage (Vo) representing said addition constant.

8. The oscillator according to any of claims 4 through 7, further comprising data input means (10) for receiving data from a source (11) outside the oscillator and for allowing said data to be stored into the data memory means (4; 54).

9. The oscillator according to any one of claims 4 through 8, wherein the data memory means (4; 54) further holds frequency setting data, and the oscillator further comprises:
deviation compensating means (7) responsive to said frequency setting data for compensating any deviation of the characteristic frequency of said vibrator (9) at a reference temperature from a desired frequency.

10. The oscillator according to any one of claims 1 through 8, further having a control input terminal for receiving a control voltage (Vc) and adder means (27) for adding said control voltage to said power supply voltage (VDD(T)) for compensating any deviation of the characteristic frequency of said vibrator (9) at a reference temperature from a desired frequency.

11. The oscillator according to any one of claims 1 to 10, wherein the variable power supply circuit (15; 51) raises said power supply voltage as the sensed temperature rises.

12. The oscillator according to any one of claims 1 through 11, wherein components other than the piezoelectric vibrator (9) are integrated into a one-chip IC (41; 241).

13. The oscillator according to claim 12, wherein the one-chip IC is packaged along with the piezoelectric vibrator (9) into a mold (40).

14. The oscillator according to claim 12, wherein the one-chip IC is housed along with the piezoelectric vibrator (9) into a package.

## Patentansprüche

1. Temperaturkompensierter piezoelektrischer Oszillator mit
einem piezoelektrischen Schwinger (9), dessen Frequenz eine Temperaturabhängigkeit besitzt,
einer Oszillatorschaltung (8) zum Treiben des Schwingers (9) und zum Ändem der Schwingfrequenz in Abhängigkeit von einer Energieversorgungsspannung (VDD(T)), die an die Oszillatorschaltung angelegt ist,
einer Temperatursensorschaltung (2) zum Erfassen der Umgebungstemperatur des Schwingers (9), und
einer variablen Energieversorgungsschaltung (15; 51), die auf die Temperatursensorschaltung anspricht und zum Erzeugen der Energieversorgungsspannung derart ausgelegt ist, daß die Schwingfrequenz der Oszillatorschaltung (8) in Abhängigkeit von Änderungen der Umgebungstemperatur so geändert wird, daß die Temperaturabhängigkeit der Frequenz des Schwingers (9) kompensiert wird,
**dadurch gekennzeichnet, daß**
die variable Energieversorgungsschaltung (15; 51) eine Begrenzerschaltung (30) enthält, die den Bereich der Energieversorgungsspannung (VDD(T)) begrenzt.

2. Oszillator nach Anspruch 1, bei dem die obere Grenze des Bereichs auf eine Spannung festgelegt ist, die niedriger ist als die Energieversorgungsspannung des temperaturkompensierten piezoelektrischen Oszillators (1; 50) selbst.

3. Oszillator nach Anspruch 1 oder 2, bei dem die untere Grenze des Bereichs auf eine Spannung festgelegt ist, die höher ist als die Schwingungseinsetzspannung der Oszillatorschaltung (8).

4. Oszillator nach Anspruch 1, 2 oder 3, bei dem die variable Energieversorgungsschaltung (51) eine Datenspeichereinrichtung (54) zum Speichem jeweiliger kompensierender Daten für eine Vielzahl von unterschiedlichen Umgebungstemperaturen, und eine Einrichtung (52; 53) zum Auslesen von kompensierenden Daten, die der durch die Temperatursensorschaltung (2) erfaßten Umgebungstemperatur entsprechen, aus der Datenspeichereinrichtung umfaßt, wobei die variable Energieversorgungsschaltung derart ausgelegt ist, daß sie die Energieversorgungsspannung (VDD(T)) in Abhängigkeit von den kompensierenden, aus der Datenspeichereinrichtung ausgelesenen Daten ändert.

5. Oszillator nach Anspruch 1, 2 oder 3, bei dem
die Temperaturabhängigkeit der Frequenz des Schwingers (9) durch eine Funktion${\text{f(T) = A(T-25)+B(T-25)}}^{\text{2}} {\text{+C(T-25)}}^{\text{3}}$
approximiert wird, wobei T die Umgebungstemperatur T, A einen linearen Koeffizienten, B einen quadratischen Koeffizienten und C einen kubischen Koeffizienten bezeichnen,
wobei die variable Energieversorgungsschaltung (15) eine Datenspeichereinrichtung (4) zum Speichern von kompensierenden Daten zur Kompensation von Frequenzänderungen enthält, die mindestens einem der drei Ausdrücke der Funktion f(T) entsprechen, und
wobei die variable Energieversorgungsschaltung die Energieversorgungsspannung (VDD(T)) auf der Basis der kompensierenden Daten, die aus der Datenspeichereinrichtung ausgelesen werden, und der durch die Temperatursensorschaltung (2) erfaßten Umgebungstemperatur erzeugt.

6. Oszillator nach Anspruch 5, bei dem die kompensierenden Daten einen Multiplikationskoeffizienten G und eine Additionskonstante H enthalten, und
die variable Energieversorgungsschaltung (15) dazu ausgelegt ist, die Energieversorgungsspannung (VDD(T)) entsprechend der linearen Funktion V(T) = G(T) + H zu erzeugen.

7. Oszillator nach Anspruch 6, bei dem die variable Energieversorgungsschaltung (15) eine Verstärkereinrichtung (20) mit variablem Verstärkungsfaktor und variablem Offset enthält, die einen mit der Temperatursensorschaltung (2) verbundenen Eingangsanschluß, einen zur Verstärkungsfaktorsteuerung dienenden Eingangsanschluß, der zur Aufnahme einer den Multiplikationskoeffizienten repräsentierenden Verstärkungsfaktor-Steuerspannung (Vg) ausgelegt ist, und einen zur Offsetsteuerung dienenden Eingangsanschluß umfaßt, der zur Aufnahme einer Offsetsteuerspannung (Vo), die die Additionskonstante repräsentiert, ausgelegt ist.

8. Oszillator nach einem der Ansprüche 4 bis 7, der weiterhin eine Dateneingabeeinrichtung (10) zum Aufnehmen von Daten von einer außerhalb des Oszillators befindlichen Quelle (11) und zum Ermöglichen der Speicherung dieser Daten in der Datenspeichereinrichtung (4; 54) enthält.

9. Oszillator nach einem der Ansprüche 4 bis 8, bei dem die Datenspeichereinrichtung (4; 54) weiterhin Frequenzeinstelldaten speichert und der Oszillator zusätzlich aufweist:
eine Abweichungskompensationseinrichtung (7), die auf die Frequenzeinstelldaten anspricht und zum Kompensieren irgend welcher Abweichungen der Eigenfrequenz des Schwingers (9) bei einer Referenztemperatur von einer gewünschten Frequenz ausgelegt ist.

10. Oszillator nach einem der Ansprüche 1 bis 8, der weiterhin einen Steuereingangsanschluß zum Aufnehmen einer Steuerspannung (Vc) und eine Addiereinrichtung (27) zum Addieren der Steuerspannung zu der Energieversorgungsspannung (VDD(T)) zum Kompensieren irgend welcher Abweichungen der Eigenfrequenz des Schwingers (9) bei einer Referenztemperatur von einer gewünschten Frequenz umfaßt.

11. Oszillator nach einem der Ansprüche 1 bis 10, bei dem die variable Energieversorgungsschaltung (15; 51) die Energieversorgungsspannung bei einem Anstieg der erfaßten Temperatur erhöht.

12. Oszillator nach einem der Ansprüche 1 bis 11, bei dem die Komponenten mit Ausnahme des piezoelektrischen Schwingers (9) in einem Einzelchip-iC (41; 241) integnert ausgebildet sind.

13. Oszillator nach Anspruch 12, bei dem der Einzelchip-iC zusammen mit dem piezoelektrischen Schwinger (9) in einem Gußteil (40) untergebracht ist.

14. Oszillator nach Anspruch 12, bei dem der Einzelchip-iC zusammen mit dem piezoelektrischen Schwinger (9) in einem Gehäuse untergebracht ist.

## Revendications

1. Oscillateur piézo-électrique compensé en température comportant
un vibrateur (9) piézo-électrique ayant des caractéristiques fréquence-température,
un circuit (8) oscillateur destiné à attaquer le vibrateur (9) et destiné à modifier la fréquence d'oscillation en réponse à une tension (VDD(T)) d'alimentation en puissance appliquée au circuit oscillateur,
un circuit (2) formant capteur de température destiné à détecter la température ambiante du vibrateur (9), et
un circuit (15 ; 51) d'alimentation en puissance variable sensible au circuit formant capteur de température et destiné à produire la tension d'alimentation en puissance de manière à modifier, en réponse à des variations de température ambiante, la fréquence d'oscillation du circuit (8) formant oscillateur pour compenser les caractéristiques fréquence-température du vibrateur (9),
caractérisé en ce que
le circuit (15 ; 51) d'alimentation en puissance variable comprend un circuit (30) limiteur qui limite le domaine de la tension (VDD(T)) d'alimentation en puissance.

2. Oscillateur suivant la revendication 1, dans lequel la limite supérieure du domaine est réglée à une tension inférieure à la tension d'alimentation en puissance envoyée à l'oscillateur (1 ; 50) piézo-électrique compensé en température soi-même.

3. Oscillateur suivant la revendication 1 ou 2, dans lequel la limite inférieure du domaine est réglée à une tension supérieure à une tension de coupure d'oscillation du circuit (8) oscillateur.

4. Oscillateur suivant la revendication 1, 2 ou 3, dans lequel le circuit (51) d'alimentation en puissance variable comprend des moyens (54) de mémoire de données destinés à stocker une pluralité de données de compensation respectives de températures ambiantes différentes, et des moyens (52 ; 53) destinés à lire à partir de ces moyens de mémoire de données des données de compensation correspondant à la température ambiante détectée par le circuit (2) formant capteur de températures dans lequel le circuit d'alimentation en puissance variable est adapté pour modifier la tension (VDD(T)) d'alimentation en puissance en réponse aux données de compensation lues dans les moyens de mémoire de données.

5. Oscillateur suivant la revendication 1, 2 ou 3, dans lequel
la caractéristique fréquence-température du vibrateur (9) est approchée par une fonction${\text{f(T) = A(T-25) + B(T-25)}}^{\text{2}} {\text{+ C(T-25)}}^{\text{3}}$
dans laquelle T représente la température T ambiante, A est un coefficient linéaire, B est un coefficient quadratique et C est un coefficient cubique,
le circuit (15) d'alimentation en puissance variable comprend des moyens (4) de mémoire de données destinés à stocker des données de compensation destinées à compenser des variations en fréquence correspondant à au moins l'un des trois termes de la fonction f(T), et
le circuit d'alimentation en puissance variable produit la tension (VDD(T)) d'alimentation en puissance sur la base des données de compensation lues des moyens de mémoire de données et de la température ambiante détectée par le circuit (2) formant capteur de température.

6. Oscillateur suivant la revendication 5, dans lequel des données de compensation comportent un coefficient G de multiplication et une constante H d'addition, et
le circuit (15) d'alimentation en puissance variable est adapté pour produire la tension (VDD(T)) d'alimentation en puissance correspondant à une fonction linéaire V(T) = G(T) + H.

7. Oscillateur suivant la revendication 6, dans lequel le circuit (15) d'alimentation en puissance variable comprend un gain variable et des moyens (20) d'amplification de décalage variable ayant une borne d'entrée connectée au circuit (2) formant capteur de température, une borne d'entrée de commande de gain adaptée pour recevoir une tension (Vg) de commande de gain représentant le coefficient de multiplication et une borne d'entrée de commande de décalage adaptée pour recevoir une tension (Vo) de commande de décalage représentant la constante d'addition.

8. Oscillateur suivant l'une quelconque des revendications 4 à 7, comprenant en outre des moyens (10) d'entrée de données destinés à recevoir des données à partir d'une source (11 ) à l'extérieur de l'oscillateur et destinés à permettre aux données d'être stockées dans les moyens (4 ; 54) de mémoire de données.

9. Oscillateur suivant l'une quelconque des revendications 4 à 8, dans lequel les moyens (4 ; 54) de mémoire de données conservent en outre des données de réglage de fréquence, et l'oscillateur comprend en outre :
des moyens (7) de compensation d'écarts sensibles aux données de réglage de fréquence et destinés à compenser tout écart de la fréquence caractéristique du vibrateur (9) à une température de référence par rapport à une fréquence souhaitée.

10. Oscillateur suivant l'une quelconque des revendications 1 à 8, ayant en outre une borne d'entrée de commande destinée à recevoir une tension (Vc) de commande et des moyens (27) additionneurs destinés à additionner la tension de commande à la tension (VDD(T)) d'alimentation en puissance destinée à compenser tout écart de la fréquence caractéristique du vibrateur (9) à une température de référence par rapport une fréquence souhaitée.

11. Oscillateur suivant l'une quelconque des revendications 1 à 10, dans lequel le circuit (15 ; 51) d'alimentation en puissance variable élève la tension d'alimentation en puissance au fur et à mesure que la température détectée augmente.

12. Oscillateur suivant l'une quelconque des revendications 1 à 11, dans lequel des composants autres que le vibrateur (9) piézo-électrique sont intégrés en un circuit intégré (41 ; 241) à une puce.

13. Oscillateur suivant la revendication 12, dans lequel le circuit intégré à une puce est emballé avec le vibrateur (9) piézo-électrique en un moule (40).

14. Oscillateur suivant la revendication 12, dans lequel le circuit intégré à une puce est logé avec le vibrateur (9) piézo-électrique dans un module.
